# EUROPEAN PATENT APPLICATION

(11) **EP 1 686 718 A2**
(43) Date of publication of application: **02.08.2006**
(21) Application number: 06001108.7
(22) Date of filing: 19.01.2006
(51) Int. Cl.: H04L 1/18

(54) **Method of CRC residue error detection and handling**

(30) Priority: 26.01.2005 US 593560 P; 03.02.2005 US 593662 P
(71) Applicant: ASUSTeK Computer Inc., Peitou, Taipei City (TW)
(72) Inventor: Jiang, Sam, Taipei City, Taiwan (TW)
(74) Representative: Schaeberle, Steffen

(57) **Abstract**

A method of cyclic redundancy check, CRC, residue error detection and handling, which includes storing a plurality of protocol data units sequentially, checking sequence numbers of the plurality of protocol data units sequentially, discarding a protocol data unit when a sequence number of the protocol data unit and a sequence number of an immediately preceding protocol data unit are non-consecutive and the sequence number of the protocol data unit and a sequence number of an immediately succeeding protocol data unit are non-consecutive.

## Description

The present invention relates to a method and device of cyclic redundancy check (CRC) residue error detection and handling according to the pre-characterizing clauses of claims 1 and 7.

As the information era arrives, the demand for digital mobile communication and other types of mobile services is increasing everyday. The conventional mobile communication system has reached its peak in terms of traffic and has insufficient transmission speed. Therefore, a third generation mobile communication system, developed by an organization called 3^{rd} Generation Partnership Project (3GPP) , is created to provide services such as high frequency utility rate and high-speed transmission. In comparison to the technology of the second-generation mobile communication system, the third generation mobile communication system utilizes a radio receiving method of wideband code division multiple access (WCDMA) . WCDMA is capable of providing better performance in frequency efficiency, radio coverage, communication quality and transmission speed for multi-media applications. At the same time, it is also capable of satisfying different quality of service (QoS) requirements to provide a flexible transmission service for better communication quality with reduced abnormal disconnection rate.

A WCDMA protocol stack can be segmented into access stratum (AS) and non-access stratum (NAS) wherein the AS includes a radio resource control (RRC), radio link control (RLC), media access control (MAC), packet data convergence protocol (PDCP), broadcast/multicast control (BMC) and other sub-layers of different functions. The main function of the RLC layer communication protocol is to perform segmentation, transmission, retransmission and reassembly according to the transmission quality requirement. In the third generation mobile communication system, the transmission quality is graded into four different grades such as conversational, streaming, interactive and background. The RLC operates in three modes to satisfy different transmission quality requirements. The three modes are listed in the following:
1. Transparent mode (TM): The packet data may be segmented according to its length only. No other action is processed. TM is suitable for real time transmission services, such as voice calls.
2. Unacknowledged mode (UM): In UM, a header is added before the packet data to assist the receiver to perform a check on the sequence number of the packet data and to discard erroneous packet data if any. UM is suitable for sequential real time transmission services, such as voice over Internet protocol (VoIP), videophone and so on.
3. Acknowledged mode (AM): To ensure that the transmitted packet data can be correctly received by the receiver, AM includes functions of sequential ordering, re-transmitting, duplicate checking and so on. AM is suitable for a high-accuracy data service such as web browsing, electronic mail, file transfer and so on.

Furthermore, the RLC layer further provides packet data processing services, such as: flow control, packet data reordering, data encryption and error detection, to provide a complete packet transmission service.

Through the radio transmission, security issues for both user data and signaling messages are important. The conventional third generation mobile communication system performs encryption on transmitted data via a ciphering method.

There is a need then for a method which, prevents the error of mistakenly incrementing a hyper frame number value in a third generation mobile communications system.

This in mind, the present invention aims providing a method that detects and discards a protocol data unit (PDU) when a sequence number (SN) of the protocol data unit is non-consecutive to sequence numbers of protocol data units preceding to and following to the protocol data unit.

This is achieved by a method of cyclic redundancy check (CRC) residue error detection and handling according to claims 1 and 7. The dependent claims pertain to corresponding further developments and improvements.

As will be seen more clearly from the detailed description following below, a claimed method includes, discarding a protocol data unit when a sequence number of the protocol data unit and a sequence number of a preceding protocol data unit are non-consecutive and the sequence number of the protocol data unit and a sequence number of a following protocol data unit are non-consecutive.

In the following, the invention is further illustrated by way of example, taking reference to the accompanying drawings. Thereof
Fig. 1 illustrates a diagram of encryption and decryption in a conventional third generation mobile communication system.
Fig. 2 illustrates a flowchart of error detection according to a first embodiment of the present invention.
Fig. 3 illustrates a flowchart of error detection according to a second embodiment of the present invention.
Fig. 4 illustrates a functional block diagram of a wireless communication device, and
Fig. 5 illustrates a diagram of a program code as illustrated in Fig. 4.

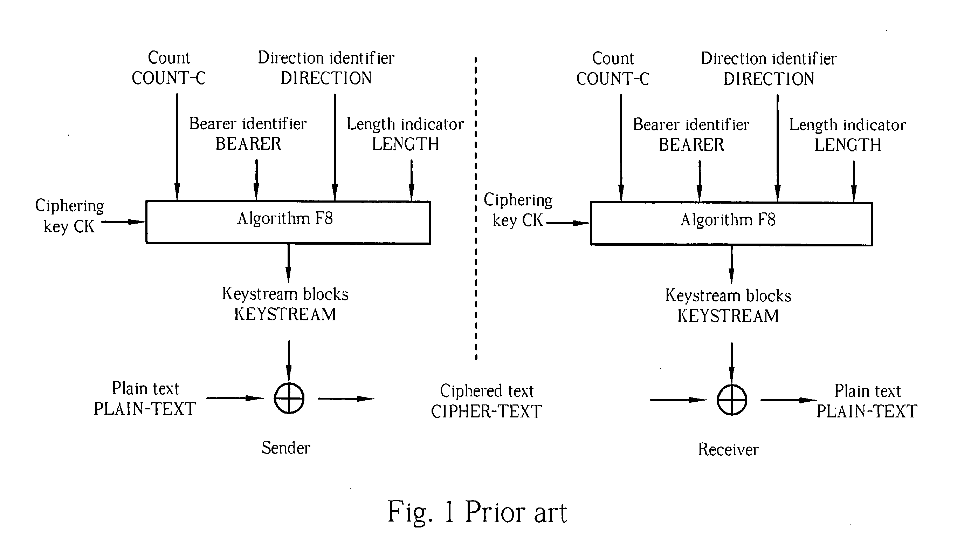

Please refer to Fig. 1. Fig. 1 illustrates a diagram of encryption and decryption in a conventional third generation mobile communication system. At a sender, a set of parameters, like ciphering key CK, count COUNT-C, bearer identifier BEARER, direction identifier DIRECTION and length indicator LENGTH, generate a plurality of keystream blocks KEYSTREAM via the algorithm F8. KEYSTREAM will further be combined with plain text PLAIN-TEXT by an exclude-OR operation to form ciphered text CIPHER-TEXT. Conversely, a receiver will perform decryption by combining KEYSTREAM and the ciphered text received with an exclude-OR operation to recover the plain text. The parameter LENGTH affects only the length of the KEYSTREAM, not the actual content of the bits in KEYSTREAM. The COUNT-C is 32-bit long and has a hyper frame number (HFN) field and a sequence number (SN) field. When a SN value exceeds the maximum value that can be represented by the SN field, the SN will be wrapped around to its initial value 0 and the HFN will be incremented by value 1. For example, when SN field has seven bits, the SN counts from 0 to 127 sequentially. When the SN exceeds 127, the HFN will be incremented by value 1, and the SN will re-start at 0. When the sequence number 127 returns to 0, these two sequence numbers, 127 and 0, are viewed as consecutive sequence numbers. SN value is inserted in each protocol data unit, and initial value of the HFN is already synchronized between the sender and the receiver before the encryption process begins. HFNs in the sender and the receiver are maintained separately during the data transmission period. Therefore, the HFNs must be maintained correctly by the sender and the receiver in order to be kept in synchronization to ensure that the process of encryption and decryption operates smoothly.

In the WCDMA communication protocol, Layer 1 (L1), which is below the RLC layer, includes a cyclic redundancy check (CRC) mechanism, for checking accuracy of a received protocol data unit. If an error is found by the CRC mechanism, which means that the protocol data unit is corrupted during transmission, the protocol data unit will be discarded and will not be delivered to the upper layers, e.g., the RLC layer. Only if there is no error found in the protocol data unit when it is checked by the CRC mechanism, the protocol data unit will be delivered to the RLC layer for further processing.

In general, the CRC includes 12 or 16 bits. There are probabilities that SN field is corrupted but the CRC mechanism is unable to detect the corruption. This kind of error is called a CRC residue error. If the CRC residue error occurs, it may induce an incorrect SN wrap-around and the HFNs will be out of synchronization between the sender and the receiver. For example, the SN is represented by a 7 bit, and the sender transmits protocol data units of SN = 0, 1, 2, 3, 4, 5, ... with HFN = 1. Suppose that protocol data unit of SN = 3 is corrupted during radio transmission while not detected by CRC mechanism at the receiver, i.e. a CRC residue error occurs at the receiver, the sequence numbers of the protocol data units received by the receiver are 0, 1, 2, 30, 4, 5, ... wherein the fourth protocol data unit, originally transmitted with SN = 3, has become SN = 30. As SN = 30 is non-consecutive with the SN = 2, in a conventional receiver, the protocol data units of SN = 3 to SN = 29 with HFN = 1 will be considered as lost (which in fact are not lost) . When the receiver receives the fifth protocol data unit of SN = 4, the conventional receiver will treat the protocol data unit of SN = 4 as a protocol data unit of SN = 4 of a next cycle (which is HFN = 2), hence the HFN is incremented by value 1. In other words, when the receiver receives the fifth protocol data unit of SN = 4, which is less than SN = 30, the receiver will consider the sequence numbers after SN = 30 in HFN = 1 up to and including SN = 3 of the next cycle (HFN = 2) as lost (which in fact are not) . Therefore, HFNs of the sender and the receiver becomes out of synchronization, and all the protocol data units after SN = 4 will be affected so that deciphering at the receiver will not work properly. The prior art further provides a receiving window for UM to solve the above-mentioned problem. But this method will also cause an error during transporting the protocol data units. For example, if the size of the receiving window is 40, the sequence numbers of the protocol data units received by the receiver are: SN = 0, 1, 2, 30, 4, 5, ... 30, 31, 32... and, as shown in this sequence, the fourth SN of the protocol data unit is a corrupted one. However, SN = 30 and SN = 2 still fall within the range of the receiving window (from 2 + 1 = 3 to 3 + 40 - 1 = 42). Therefore, the receiving window will not discard the protocol data unit of SN = 30, but instead, the fifth to the thirty first protocol data units (SN = 4 to SN = 30) will be discarded as they are mistaken to be out of the range of the receiving window (from 30 + 1 = 31 to 31 + 40 - 1 = 70). In short, although the receiving window used for UM is capable of discarding protocol data units that are out of the receiving window, if the corrupted SN is located in the receiving window, the corrupted SN will not be filtered out and the normal protocol data unit received will be discarded by mistake.

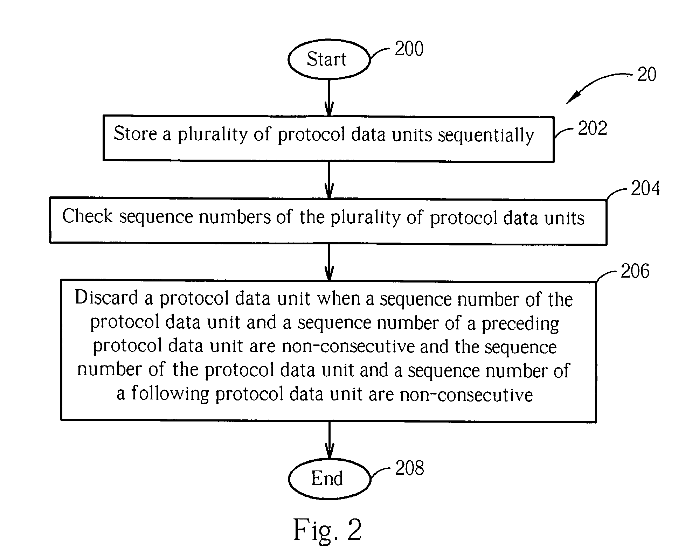

Please refer to Fig. 2. Fig. 2 illustrates a flowchart 20 of error detection according to a first embodiment of the present invention. The flowchart 20 is utilized in a receiver of a mobile communication system for detecting and handling CRC residue error. The flowchart 20 comprises the following steps:
- Step 200:: Start.
- Step 202:: Store a plurality of protocol data units sequentially.
- Step 204:: Check sequence numbers of the plurality of protocol data units.
- Step 206:: Discard a protocol data unit when a sequence number of the protocol data unit and a sequence number of a preceding protocol data unit are non-consecutive and the sequence number of the protocol data unit and a sequence number of a following protocol data unit are non-consecutive.
- Step 208:: End.

According to the flowchart 20, the present invention discards a protocol data unit when a sequence number of the protocol data unit and a sequence number of a preceding protocol data unit are non-consecutive and the sequence number of the protocol data unit and a sequence number of a following protocol data unit are non-consecutive. Therefore, the error of mistakenly incrementing the HFN value can be prevented. For an RLC entity operating in unacknowledged mode, since there is no effective error detection functionality, the present invention is particularly needed to keep HFN in synchronization between the sender and receiver.

For example, if sequence numbers of a plurality of protocol data units sequentially transmitted by the sender are 0, 1, 2, 3, 4, 5, ... and so on with HFN = 1. Suppose that a CRC residue error occurs at the receiver, and the sequence numbers of the protocol data units received by the receiver become 0, 1, 2, 30, 4, 5, ... and so on, wherein the fourth protocol data unit originally transmitted with SN = 3 has been corrupted into SN = 30. According to the flowchart 20, since the SN = 30 is non-consecutive with the SN = 2 and SN = 4, SN = 30 will be discarded so that the HFN will not be incremented but rather maintained at 1 for all received protocol data units. Therefore, normal deciphering operation can be maintained to perform for all the received protocol data units.

Please note that, according to the flowchart 20, the present invention will only discard a protocol data unit when a sequence number of the protocol data unit and a sequence number of a preceding protocol data unit are non-consecutive and the sequence number of the protocol data unit and a sequence number of a following protocol data unit are non-consecutive. If a sequence number of a protocol data unit is non-consecutive to only a sequence number of a protocol data unit preceding or following to the protocol data unit, it does not fulfill the condition of the present invention. However, if the protocol data unit is the first protocol data unit received by the receiver, there is no preceding protocol data unit. An option of this invention is to discard the first received protocol data unit when the sequence number of the first received protocol data unit is not a predefined initial value and the sequence number of the first received protocol data unit is non-consecutive to a sequence number of a protocol data unit following to the first received protocol data unit. In general, the predefined initial value is 0.

In comparison to the prior art, the present invention is capable of detecting and handling CRC residue error to prevent the error of mistakenly incrementing HFN value. Hence, the reception efficiency is improved to overcome the defects of the prior art.

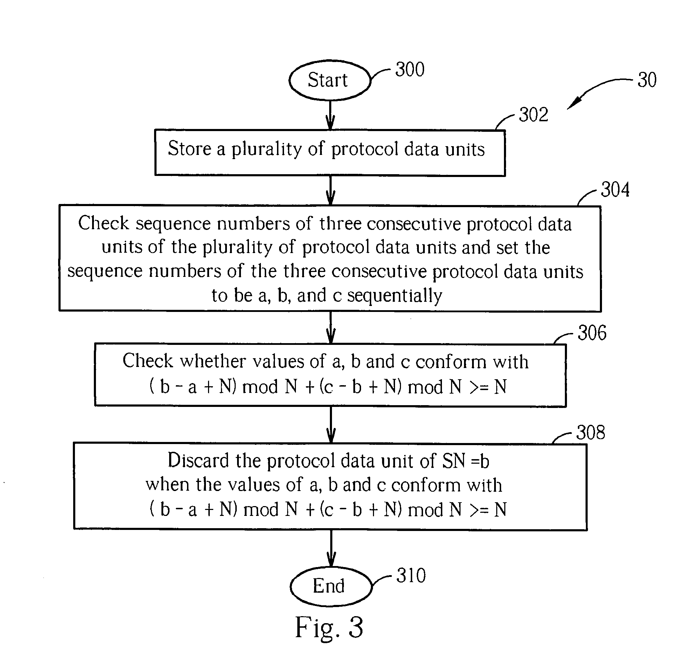

Therefore, according to the flowchart 20, the present invention is capable of discarding a protocol data unit of isolated sequence number to improve on the efficiency of reception. In addition, the isolated sequence number can simply be caused by transmission loss of protocol data units. Under these circumstances, the first embodiment of the present invention may discard a correct protocol data unit. For example, suppose the sequence numbers of a block of protocol data units transmitted by the sender are 0, 1, 2, 3, 4, 5, ... and so on. Suppose there is an error during radio transmission, and the sequence numbers of the protocol data units received by the receiver become 0, 1, 2, 30, 4, 6, 7, and so on, wherein the fourth protocol data unit originally transmitted with SN = 3 has been corrupted into SN = 30, and the protocol data unit with SN = 5 is lost during radio transmission. For this scenario, if according to the flowchart 20, since the SN = 30 is non-consecutive with the SN = 2 and SN = 4, SN = 30 will be discarded. Then, since the SN = 4 is non-consecutive with the SN = 2 and SN = 6, SN = 4 will also be discarded so that the protocol data unit with SN = 4 will be discarded wrongly. In order to overcome the above-mentioned problem, the present invention provides another option. Please refer to Fig. 3. Fig. 3 illustrates a flowchart 30 of error detection and handling according to a second embodiment of the present invention. The flowchart 30 is utilized in a receiver of a mobile communication system for detecting and handling CRC residue error. The flowchart 30 comprises the following steps:
- Step 300:: Start.
- Step 302:: Store a plurality of protocol data units.
- Step 304:: Check sequence numbers of three consecutive protocol data units of the plurality of protocol data units and set the sequence numbers of the three consecutive protocol data units to be a, b, and c sequentially.
- Step 306:: Check whether values of a, b and c conform with (b - a + N) modN+ (c-b+N) mod N >= N, wherein N = 2^{k}, k is bit length of the sequence number, mod represents remainder calculation.
- Step 308:: Discard the protocol data unit of SN = b when the values of a, b and c conform with (b - a + N) mod N + (c - b + N) mod N >= N.
- Step 310:: End.

According to the flowchart 30, the present invention checks whether values of a, b and c conforms with: (b - a + N) mod N + (c - b + N) mod N >= N. When the values of a, b and c conform to the formula, the protocol data unit of SN = b will be discarded. This check can prevent correctly received protocol data units from being discarded. For example, for a system that utilizes a 7 bit sequence number, the sequence numbers of the protocol data units sequentially transmitted by the sender are 0, 1, 2, 3, 4, 5, ... and so on. Suppose that there is an error during radio transmission, and the sequence numbers of the protocol data units received by the receiver become 0, 1, 2, 30, 4, 6, 7, and so on, wherein the fourth protocol data unit originally transmitted with SN = 3 has been corrupted into SN = 30, and SN = 5 is lost during radio transmission. According to the flowchart 30, as for the first three sequence numbers SN = 0, 1, 2, applying the formula, we have (1 - 0 + 128) mod 128 + (2 - 1 + 128) mod 128 = 1 + 1 = 2 < 128. Therefore SN = 0, 1, 2 do not conform to the above formula. Similarly, SN = 1, 2, 30 also do not conform to the above formula. As for SN = 2, 30, 4, applying the formula, we have (30 - 2 + 128) mod 128 + (4 -30 + 128) mod 128 = 28 + 102 = 130 > 128. Therefore, SN = 2, 30, 4 conform to the condition of the above checking formula so that the protocol data unit of SN = 30 is discarded. Furthermore, for SN = 2, 4, 6 (SN = 30 already being deleted), since (4 - 2 + 128) mod 128 + (6 - 4 + 128) mod 128 = 2 + 2 = 4 < 128, SN = 2, 4, 6 do not conform to the condition of the flowchart 30 so that the protocol data unit of SN = 4 is not discarded.

In comparison with the flowchart 20, the flowchart 30 is able to prevent the error of mistakenly incrementing the HFN value and also prevent the non-consecutive sequence numbers caused by packet loss during radio transmission from being discarded. Hence, reception efficiency is further increased, system cost is reduced and the defects of the prior art are overcome.

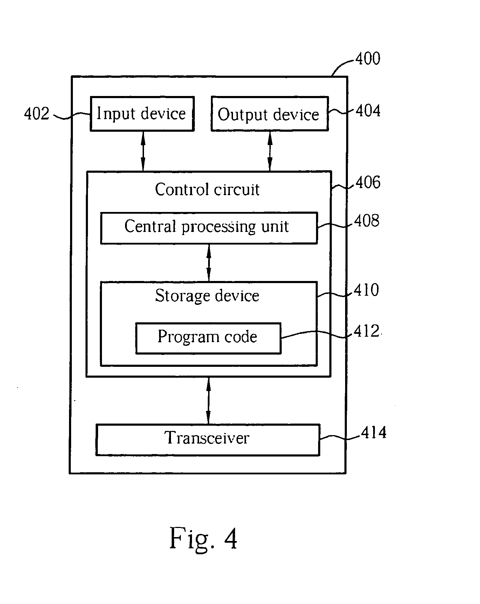

Please refer to Fig. 4. Fig. 4 illustrates a functional block diagram of a wireless communication device 400. The wireless communication device 400 of Fig. 4 includes an input device 402, an output device 404, a control circuit 406, a central processing unit 408, a storage device 410, a program code 412, and a transceiver 414. In the wireless communication device 400, the control circuit 406 via the central processing unit 408 executes the program code 412 stored within the storage device 410. The operations of the wireless communication device 400 can be controlled through the input device 402 (such as a keyboard) for receiving signals inputted by a user, or through the output device 404 (such as a screen or speakers) for outputting images and sounds. The transceiver 414 is utilized for receiving wireless signals which are then transmitted to the control circuit 406, and is utilized for outputting the messages received from the control circuit 406 in a wireless manner. In other words, under the structure of the communications protocol stack, the transceiver 414 can be viewed as a part of layer 1 of the stack, and the control circuit 406 is utilized to realize the functionalities of layer 2 and layer 3 of the stack.

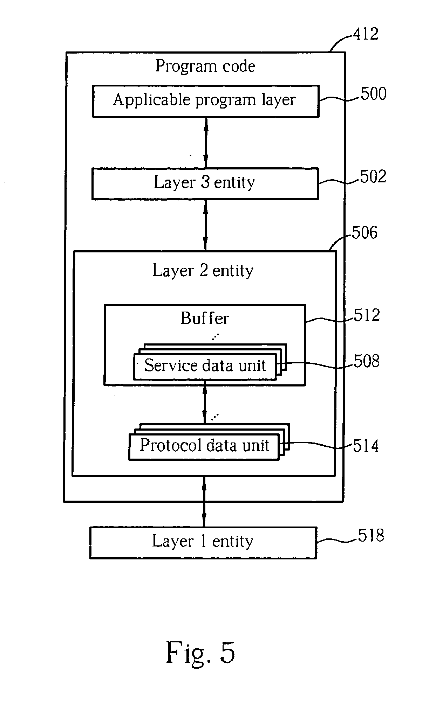

Please refer to Fig. 5. Fig. 5 illustrates a diagram of the program code 412 of Fig. 4. The program code 412 includes an applicable program layer 500, a layer 3 entity 502, a layer 2 entity 506, and a layer 1 entity 518. When transmitting signals, layer 2 entity 506 forms a plurality of service data units 508 to be stored within a buffer 512 according to data outputted by layer 3 entity 502. Layer 2 entity 506 generates and outputs a plurality of protocol data units 514 to a destination end via layer 1 entity 518 according to the service data unit 508 within the buffer 512. On the contrary, when receiving the wireless signals through layer 1 entity 518, the signals are outputted to layer 2 entity 506 as protocol data units 514. Layer 2 entity 506 restores the protocol data units 514 as service data units 508 and stores the service data units 508 into the buffer 512. Lastly, layer 2 entity 506 transmits the service data units 508 within the buffer 512 to layer 3 entity 502.

The wireless communication device 400 has more advantages over the current 3^{rd} generation mobile communication system. When an unacknowledged mode is operated, in order to prevent the received protocol data unit from being incorrectly discarded, the present invention according to the following flowchart sets a related algorithm to solve the problem in the above-mentioned prior art.

## Claims

1. A method of cyclic redundancy check, CRC, residue error detection and handling, utilized in a receiver of a mobile communication system, the method comprising:
storing a plurality of protocol data units sequentially;
checking sequence numbers of the plurality of protocol data units; and
**characterized by**:
discarding a protocol data unit when a sequence number of the protocol data unit and a sequence number of a preceding protocol data unit are non-consecutive and the sequence number of the protocol data unit and a sequence number of a following protocol data unit are non-consecutive.

2. The method of claim 1 **characterised in that** the plurality of protocol data units are in an unacknowledged mode.

3. The method of claim 1 **characterised in that** sequence numbers of two protocol data units are consecutive when one sequence number is a greatest value and the other sequence number is a zero value.

4. The method of claim 1 further comprising discarding an initial protocol data unit when a sequence number of the initial protocol data unit is not a predefined initial value and the sequence number of the initial protocol data unit is non-consecutive to a sequence number of a protocol data unit following to the initial protocol data unit, **characterised in that** the initial protocol data unit is sequentially first protocol data unit of the plurality of protocol data units.

5. The method of claim 4 **characterised in that** the predefined initial value is zero.

6. A wireless device (400) comprising a central processing unit, CPU, in electrical communications with a memory, and the memory comprising a program code for implementing the method of claim 1.

7. A method of cyclic redundancy check, CRC, residue error detection and handling, utilized in a receiver of a mobile communication system, the method comprising:
storing a plurality of protocol data units;
checking sequence numbers of three consecutive protocol data units of the plurality of protocol data units and setting the sequence numbers of the three consecutive protocol data units to be a, b, and c sequentially;
**characterized by**:
checking whether values of a, b and c conform with (b - a + N ) mod N + ( c - b + N ) mod N > = N, wherein N = 2^{k}, k is bit length of the sequence number, mod represents remainder calculation; and
discarding the protocol data unit of sequence number b when the values of a, b and c conform with ( b - a + N ) mod N + ( c - b + N ) mod N > = N.

8. A wireless device (400) comprising a central processing unit, CPU, in electrical communications with a memory, and the memory comprising a program code for implementing the method of claim 7.
